# EUROPEAN PATENT SPECIFICATION

(11) **EP 3 939 760 B1**
(45) Date of publication and mention of the grant of the patent: **23.08.2023**
(21) Application number: 20774450.9
(22) Date of filing: 12.03.2020
(51) Int. Cl.: B28D 5/00, B23K 26/364, C04B 41/91, H05K 1/02, H05K 3/00

(54) **NITRIDE CERAMIC SUBSTRATE PRODUCTION METHOD AND NITRIDE CERAMIC BASE MATERIAL**
VERFAHREN ZUR HERSTELLUNG EINES NITRIDKERAMIKSUBSTRATS UND NITRIDKERAMIKBASISMATERIAL
PROCÉDÉ DE PRODUCTION D'UN SUBSTRAT EN CÉRAMIQUE DE NITRURE ET MATÉRIAU DE BASE EN CÉRAMIQUE DE NITRURE

(30) Priority: 15.03.2019 JP 2019048079
(43) Date of publication of application: 19.01.2022
(73) Proprietor: Denka Company Limited, Tokyo 103-8338 (JP)
(72) Inventor: YUASA Akimasa, Tokyo 103-8338 (JP); ESHIMA Yoshiyuki, Tokyo 103-8338 (JP); FUJIYOSHI Daiki, Tokyo 103-8338 (JP); KOBASHI Seiji, Tokyo 103-8338 (JP); NISHIMURA Koji, Tokyo 103-8338 (JP)
(74) Representative: Gulde & Partner
(86) International application number: PCT/JP2020/010913
(87) International publication number: WO 2020/189526

(56) References cited:
- JP-A- 2000 044 344
- JP-A- 2000 044 344
- JP-A- 2002 176 119
- JP-A- 2004 165 226
- JP-A- 2007 324 301
- JP-A- 2007 324 301
- JP-A- 2009 049 390
- JP-A- 2015 144 197
- JP-A- 2017 028 192

## Description

### TECHNICAL FIELD

The present invention relates to a method of manufacturing a nitride ceramic substrate and a nitride ceramic base material.

### BACKGROUND ART

As an electronic component, a nitride ceramic substrate may be used. The nitride ceramic substrate is excellent in various aspects, such as high thermal conductivity or high insulation properties. The nitride ceramic substrate can be used in various electronic devices, such as a power module.

Various ceramic substrates, including a nitride ceramic substrate, can be manufactured such that a ceramic base material is divided by laser scribing as described in, for example, Patent Documents 1 to 3. A scribe line is formed on the ceramic base material by laser scribing. The ceramic base material is divided into a plurality of ceramic substrates along the scribe line.

Patent Document 1 describes that a nitride ceramic base material is divided into a plurality of the nitride ceramic substrates by laser scribing. The scribe line formed by the laser scribing includes a plurality of recessed portions formed in a row on a surface of the nitride ceramic base material. An opening width of the recessed portion is 0.04 mm to 0.5 mm, a depth of the recessed portion is 1/4 to 1/3 of a thickness of the nitride ceramic base material, and an inter-center distance of the plurality of recessed portions is 0.2 mm or smaller.

Patent Document 2 describes that an aluminum oxide base material is divided into a plurality of the aluminum oxide substrates by laser scribing. The scribe line formed by the laser scribing includes a plurality of recessed portions formed in a row on a surface of the nitride ceramic base material. The recessed portion has a conical shape.

Patent Document 3 describes that a silicon nitride base material is divided into a plurality of the silicon nitride substrates by laser scribing. The scribe line formed by the laser scribing has a groove that extends continuously in one direction.

Patent Document 4 discloses a method of manufacturing a nitride ceramic substrate according to the preamble of claim 1, and a nitride ceramic base material according to the preamble of claim 10.

In particular Document 4 discloses a scribe line formed in a surface of a nitride ceramic base material and comprising a plurality of recessed portions. According to an example, the processing diameter of each recessed portion is set to be approximately the same as the arrangement pitch thereof.

### RELATED DOCUMENT

### PATENT DOCUMENT

[Patent Document 1] JP 2007-324301 A
[Patent Document 2] JP 2013-175667 A
[Patent Document 3] JP 2014-42066 A
[Patent Document 4] JP 2000-044344 A

### SUMMARY OF THE INVENTION

### TECHNICAL PROBLEM

Regarding the nitride ceramic base material, favorable removal of a brazing material from the nitride ceramic base material, reduction of appearance of a scribe line in scanning acoustic tomography (SAT), and favorable breakage of the nitride ceramic base material may be required.

An example of an object of the present invention is to achieve favorable removal of a brazing material from the nitride ceramic base material, reduction of appearance of a scribe line in SAT, and favorable breakage of the nitride ceramic base material. Other objects of the present invention will be apparent from the description of the present application.

### SOLUTION TO PROBLEM

An aspect of the present invention is a method of manufacturing a nitride ceramic substrate, the method including:
forming a scribe line on a first surface of a nitride ceramic base material by a laser; and
dividing the nitride ceramic base material along the scribe line,
in which the scribe line includes a plurality of recessed portions formed in a row on the first surface of the nitride ceramic base material,
a depth of each of the plurality of recessed portions is equal to or greater than 0.70 times and equal to or smaller than 1.10 times an opening width of each of the plurality of recessed portions, and
the opening width of each of the plurality of recessed portions is equal to or greater than 1.00 times and equal to or smaller than 1.10 times an inter-center distance of the plurality of recessed portions.

Another aspect of the present invention is a nitride ceramic base material including
a first surface on which a scribe line is formed,
in which the scribe line includes a plurality of recessed portions formed in a row on the first surface,
a depth of each of the plurality of recessed portions is equal to or greater than 0.70 times and equal to or smaller than 1.10 times an opening width of each of the plurality of recessed portions, and
the opening width of each of the plurality of recessed portions is equal to or greater than 1.00 times and equal to or smaller than 1.10 times an inter-center distance of the plurality of recessed portions.

### ADVANTAGEOUS EFFECTS OF INVENTION

According to the aspect of the present invention, favorable removal of a brazing material from the nitride ceramic base material, reduction of appearance of a scribe line in SAT, and favorable breakage of the nitride ceramic base material can be realized.

### BRIEF DESCRIPTION OF THE DRAWINGS

Fig. 1 is a plan view of a nitride ceramic base material according to an embodiment.
Fig. 2 is a cross-sectional view taken along line A-A' of Fig. 1.
Fig. 3 is an enlarged view of a recessed portion shown in Fig. 2.
Fig. 4 is a plan view of an example of the entirety of the nitride ceramic base material.
Fig. 5 is an enlarged view of a region α shown in Fig. 4.
Fig. 6 is an enlarged view of a region β shown in Fig. 4.
Fig. 7 is a diagram for explaining an example of a method of manufacturing a nitride ceramic substrate (base plate) in the embodiment.
Fig. 8 is a diagram for explaining an example of the method of manufacturing a nitride ceramic substrate (base plate) in the embodiment.
Fig. 9 is a diagram for explaining an example of the method of manufacturing a nitride ceramic substrate (base plate) in the embodiment.
Fig. 10 is a diagram for explaining an example of the method of manufacturing a nitride ceramic substrate (base plate) in the embodiment.

### DESCRIPTION OF EMBODIMENT

Hereinafter, an embodiment of the present invention will be described with reference to the drawings. In all the drawings, the same components are denoted by the same reference numerals, and the description thereof will not be repeated as appropriate.

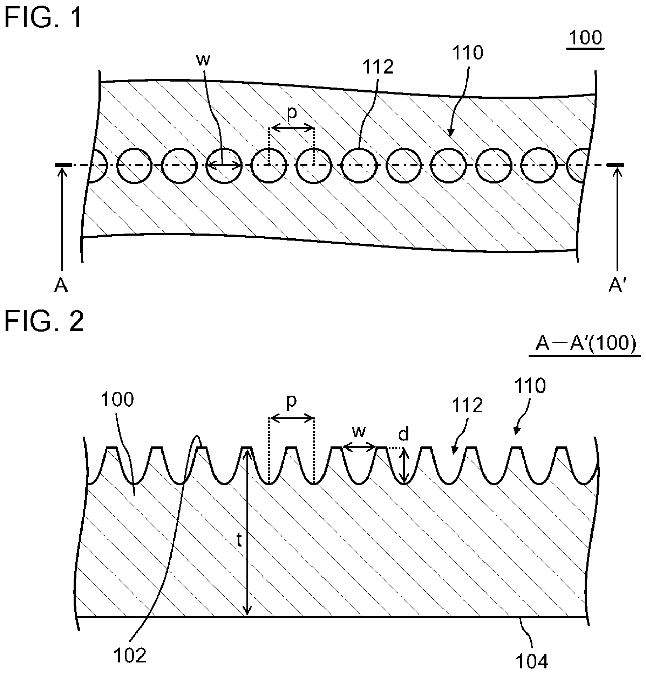

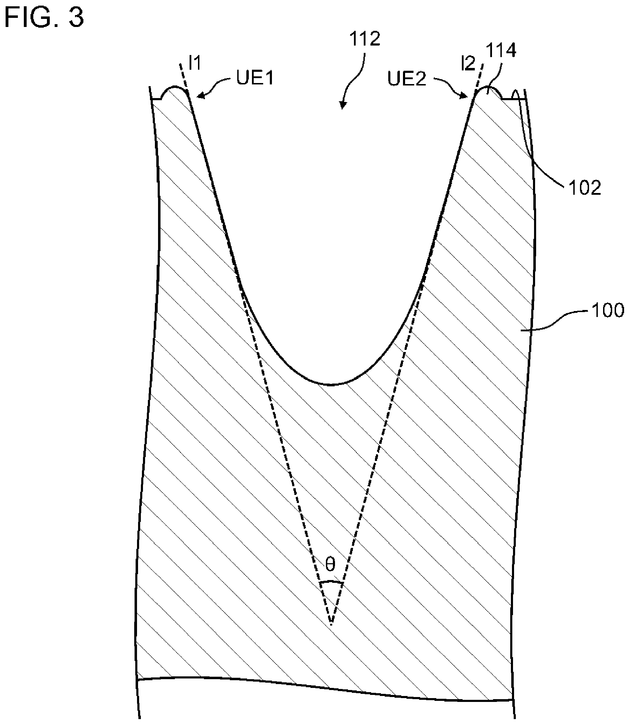

Fig. 1 is a plan view of a nitride ceramic base material 100 according to an embodiment. Fig. 2 is a cross-sectional view taken along line A-A' of Fig. 1. Fig. 3 is an enlarged view of a recessed portion 112 shown in Fig. 2.

An overview of a method of manufacturing a nitride ceramic substrate in the embodiment is illustrated using Fig. 2. First, a scribe line 110 is formed on a first surface 102 of the nitride ceramic base material 100 by a laser. Next, the nitride ceramic base material 100 is divided along the scribe line 110. The scribe line 110 includes a plurality of recessed portions 112. The plurality of recessed portions 112 are formed in a row on the first surface 102 of the nitride ceramic base material 100. A depth d of each of the plurality of recessed portions 112 is equal to or greater than 0.70 times and equal to or smaller than 1.10 times an opening width w of each of the plurality of recessed portions 112. The opening width w of each of the plurality of recessed portions 112 is equal to or greater than 1.00 times and equal to or smaller than 1.10 times an inter-center distance p of the plurality of recessed portions 112.

According to the present embodiment, favorable removal of a brazing material from the nitride ceramic base material 100, reduction of appearance of the scribe line in scanning acoustic tomography (SAT), and favorable breakage of the nitride ceramic base material 100 can be realized. As described in detail later, the present inventors have been newly found that properties of each of removal of a brazing material from the nitride ceramic base material 100, appearance of the scribe line in SAT, and breakage of the nitride ceramic base material 100 depend on various parameters, especially the depth d of the recessed portion 112, the opening width w of the recessed portion 112, and the inter-center distance p of the plurality of recessed portions 112. Studies of the present inventors have revealed that in a case where the depth d of the recessed portion 112, the opening width w of the recessed portion 112, and the inter-center distance p of the plurality of recessed portions 112 have the above-mentioned relationships, favorable removal of a brazing material from the nitride ceramic base material 100, reduction of appearance of the scribe line in SAT, and favorable breakage of the nitride ceramic base material 100 are realized.

The details of the nitride ceramic base material 100 will be described with reference to Figs. 1 and 2.

The nitride ceramic base material 100 may be, for example, a silicon nitride base material or an aluminum nitride base material, and more specifically, may be a silicon nitride sintered body base material or an aluminum nitride sintered body base material.

The nitride ceramic base material 100 has a first surface 102 and a second surface 104. In the example shown in Figs. 1 and 2, the scribe line 110 is formed on the first surface 102. The second surface 104 is located opposite to the first surface 102. A thickness t of the nitride ceramic base material 100 is a distance between the first surface 102 and the second surface 104.

The scribe line 110 includes a plurality of recessed portions 112. As shown in Fig. 1, an opening of each recessed portion 112 has a circular shape. The plurality of recessed portions 112 are disposed at substantially equal intervals (inter-center distance p) . A-A' line in Fig. 1 passes through a center of each recessed portion 112. That is, the cross-section shown in Fig. 2 includes the center of each recessed portion 112. In the example shown in Fig. 2, a width of each recessed portion 112 is narrowed toward a lower end of each recessed portion 112, and the opening width w of each recessed portion 112 is a width at an upper end of each recessed portion 112. In the example shown in Fig. 2, the depth d of each recessed portion 112 is a distance between the upper end and the lower end of each recessed portion 112.

The depth d of each recessed portion 112 may be, for example, equal to or greater than 9/64 times and equal to or smaller than 2/9 times the thickness t of the nitride ceramic base material 100, or may be equal to or greater than 45 um and equal to or smaller than 90 um. In a case where the depth d of each recessed portion 112 is too shallow, the nitride ceramic base material 100 cannot be favorably divided along the scribe line 110. On the other hand, in a case where the depth d of each recessed portion 112 is too deep, it may be difficult to remove a brazing material that has entered each recessed portion 112. On the other hand, in a case where the depth d of each recessed portion 112 is within the above-mentioned range, these obstacles can be reduced.

The details of the nitride ceramic base material 100 will be described with reference to Fig. 3.

Each of the recessed portions 112 has a conical shape with a rounded tip, and has a rounded bottom surface in the cross-section shown in Fig. 3. In the cross-section including the center of each recessed portion 112 (for example, the A-A' cross-section of Fig. 1 or the cross-section along a direction orthogonal to the A-A' line of Fig. 1), both side surfaces of the recessed portion 112 are tilted such that a virtual tangent l1 at an upper end UE1 of one inner surface of the recessed portion 112 and a virtual tangent l2 at an upper end UE2 of the other inner surface of the recessed portion 112 intersect at an angle θ (tip angle) . The tip angle θ can be, for example, equal to or greater than 30°.

The nitride ceramic base material 100 may have a ridge 114. The ridge 114 is located around the recessed portion 112. The ridge 114 is formed such that a part of the nitride ceramic base material 100 is raised due to the influence of heating by the laser.

The ridge 114 may be removed. The ridge 114 can be removed by, for example, wet blasting.

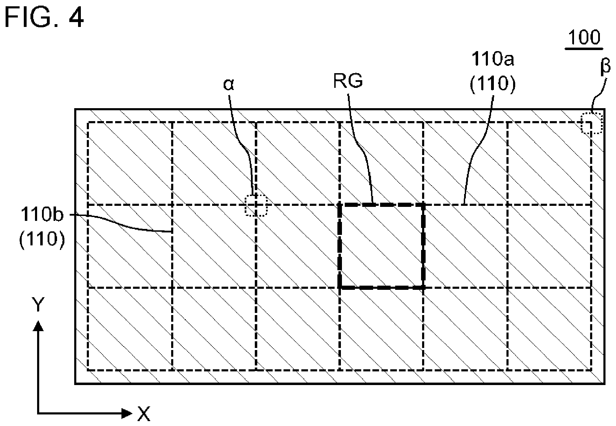

Fig. 4 is a plan view of an example of the entirety of the nitride ceramic base material 100.

The scribe line 110 of the nitride ceramic base material 100 includes a plurality of first scribe lines 110a and a plurality of second scribe lines 110b. The first scribe line 110a extends in a first direction (X direction in Fig. 4) . The second scribe line 110b extends in a second direction (Y direction in Fig. 4). The second direction intersects the first direction, and in the example shown in Fig. 4, the second direction is orthogonal to the first direction.

A plurality of sectioned regions RG are defined by the plurality of first scribe lines 110a and the plurality of second scribe lines 110b. The plurality of sectioned regions RG are arranged in a matrix. Each sectioned region RG has a substantially rectangular shape. The nitride ceramic base material 100 is divided along the scribe line 110 to cut the plurality of sectioned regions RG (a plurality of nitride ceramic substrates) out from the nitride ceramic base material 100.

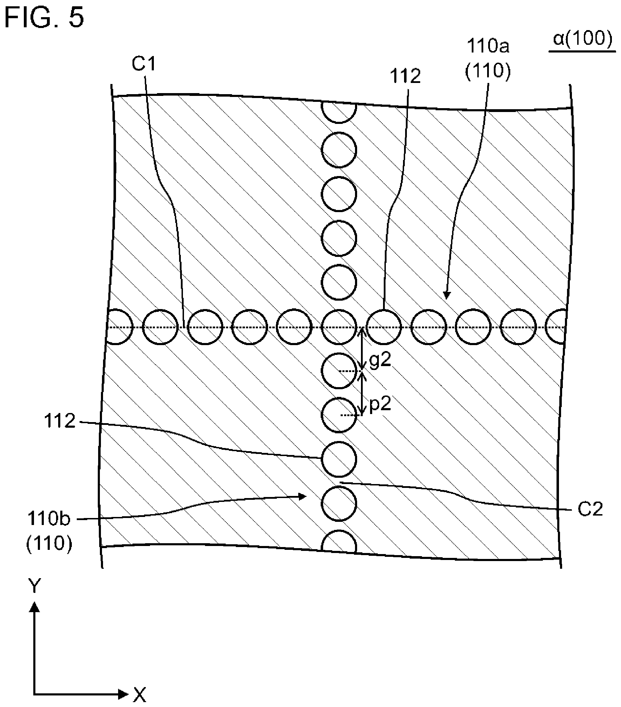

Fig. 5 is an enlarged view of a region α shown in Fig. 4. The region α includes an intersection of the scribe lines 110 formed by the intersection of the first scribe line 110a and the second scribe line 110b.

The first scribe line 110a includes a plurality of recessed portions 112 (a first group of recessed portions 112). The second scribe line 110b includes a plurality of recessed portions 112 (a second group of recessed portions 112). The recessed portion 112 located closest to the first scribe line 110a among the second group of recessed portions 112 is not overlapped with any of the first group of recessed portions 112. In a case where the first group of recessed portions 112 included in the first scribe line 110a and the second group of recessed portions 112 included in the second scribe line 110b overlap each other, there is a possibility that the nitride ceramic base material 100 may be chipped at a section where the recessed portions 112 are overlapped each other after the nitride ceramic base material 100 is divided. On the other hand, according to the present embodiment, it is possible to reduce chippings of the nitride ceramic base material 100 after the nitride ceramic base material 100 is divided.

A center of the recessed portion 112 closest to the first scribe line 110a among the second group of recessed portions 112 included in the second scribe line 110b is spaced apart from a center line C1 of the first scribe line 110a in the second direction (Y direction) by a distance g2. The distance g2 is, for example, equal to or smaller than 1.50 times, preferably equal to or smaller than 1.10 times an inter-center distance p2 of the second group of recessed portions 112. In this way, the recessed portion 112 closest to the first scribe line 110a among the second group of recessed portions 112 included in the second scribe line 110b can be disposed close to the first scribe line 110a. Therefore, favorable breakage of the nitride ceramic base material 100 at the intersection of the first scribe line 110a and the second scribe line 110b can be realized.

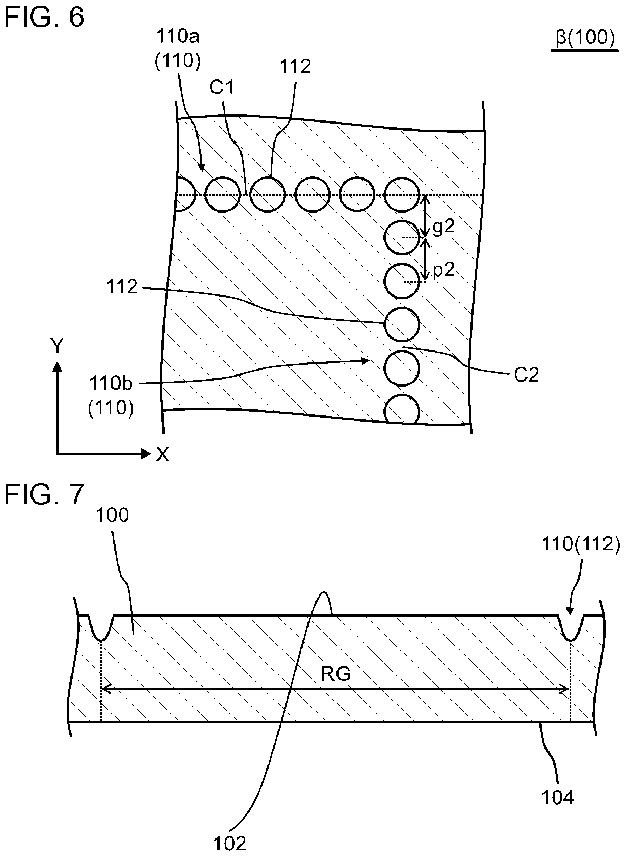

Fig. 6 is an enlarged view of a region β shown in Fig. 4. The region β includes a corner of the scribe lines 110 formed by the intersection of the first scribe line 110a and the second scribe line 110b.

At the corner of the scribe line 110 (Fig. 6), similarly to the intersection (Fig. 5) of the scribe lines 110, the recessed portion 112 located closest to the first scribe line 110a among the second group of recessed portions 112 is not overlapped with any of the first group of recessed portions 112, and the recessed portion 112 located closest to the first scribe line 110a among the second group of recessed portions 112 included in the second scribe line 110b is disposed close to the first scribe line 110a. Therefore, even at the corner of the scribe line 110 (Fig. 6), it is possible to reduce chippings of the nitride ceramic base material 100 after the nitride ceramic base material 100, and realize favorable breakage of the nitride ceramic base material 100 at the intersection of the first scribe line 110a and the second scribe line 110b.

Figs. 7 to 10 are diagrams for explaining an example of a method of manufacturing a nitride ceramic substrate (base plate) in the embodiment.

First, as shown in Fig. 7, the scribe line 110 (recessed portions 112) is formed on the first surface 102 of the nitride ceramic base material 100 by a laser. In this way, the sectioned region RG (see also Fig. 4) are defined. The laser may be, for example, a carbon dioxide laser, a fiber laser, or a YAG laser, especially a carbon dioxide laser having a pulse frequency of equal to or greater than 1 kHz, and a power of equal to or greater than 25 W and equal to or smaller than 500 W.

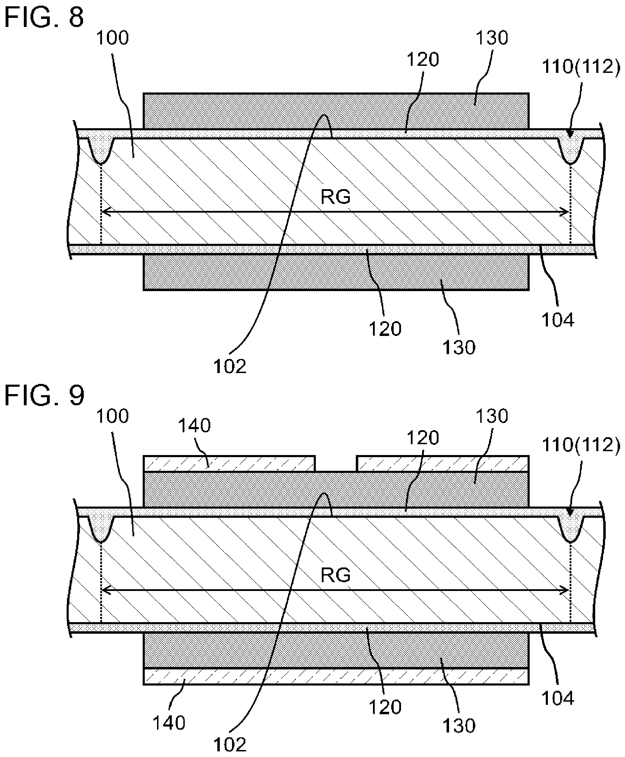

Next, as shown in Fig. 8, a brazing material 120 and a metal layer 130 are formed over each of the first surface 102 and the second surface 104 of the nitride ceramic base material 100.

The brazing material 120 may be an active metal brazing material. The active metal brazing material contains, for example, at least one of Ag, Cu, or Sn as a metal, and contains at least one of Ti or Zr as an active metal. The brazing material 120 can be formed by coating. In this case, a part of the brazing material 120 may enter the scribe line 110 (recessed portions 112).

The metal layer 130 is bonded to the nitride ceramic base material 100 through the brazing material 120.

Next, the bond between the nitride ceramic base material 100 and the metal layer 130 is inspected by ultrasonic flaw detection inspection. The present inventors have found that under certain conditions, the scribe line 110 appears in a flaw detection image obtained by the ultrasonic flaw detection inspection. The appearance of the scribe line 110 in the flaw detection image is determined to be bonding voids between the nitride ceramic base material 100 and the metal layer 130, and it is desirable to reduce the appearance of the scribe line 110 from the viewpoint that the bonding voids between the nitride ceramic base material 100 and the metal layer 130 cannot be distinguished from bonding voids caused by the brazing material 120, or are difficult to be distinguished. As described in detail later, the present inventors have been newly found that the appearance of the scribe line 110 in SAT depends on various parameters, especially the depth d of the recessed portion 112, the opening width w of the recessed portion 112, and the inter-center distance p of the plurality of recessed portions 112.

Next, as shown in Fig. 9, a resist 140 is formed on the metal layer 130 over the first surface 102 of the nitride ceramic base material 100, and the resist 140 is formed on the metal layer 130 over the second surface 104 of the nitride ceramic base material 100.

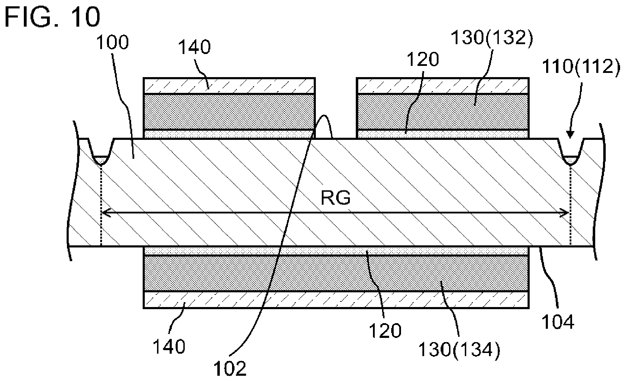

Next, as shown in Fig. 10, the brazing material 120 and the metal layer 130 are selectively etched by an etching solution (for example, a ferric chloride solution, a cupric chloride solution, and a sulfuric acid or a hydrogen peroxide solution) with the resist 140 shown in Fig. 9 remained. The metal layer 130 over the first surface 102 of the nitride ceramic base material 100 is formed in a circuit layer 132. The metal layer 130 over the second surface 104 of the nitride ceramic base material 100 is formed in a heat dissipation layer 134.

As shown in Fig. 10, the brazing material 120 may remain in the scribe line 110 (recessed portions 112). The brazing material 120 remaining in the scribe line 110 (recessed portions 112) can be removed by a solution (for example, an ammonium halide aqueous solution, an inorganic acid (for example, sulfuric acid or nitric acid), or a hydrogen peroxide solution). As described in detail later, the present inventors have been newly found that ease of entry of this solution into the scribe line 110 (recessed portions 112) (that is, the removal property of the brazing material 120 from the nitride ceramic base material 100) depends on various parameters, especially the depth d of the recessed portion 112, the opening width w of the recessed portion 112, and the inter-center distance p of the plurality of recessed portions 112.

Next, the nitride ceramic base material 100 is divided along the scribe line 110 to form a plurality of nitride ceramic substrates (base plates) . As described in detail later, the present inventors have been newly found that the property of the breakage of the nitride ceramic base material 100 depends on various parameters, especially the depth d of the recessed portion 112, the opening width w of the recessed portion 112, and the inter-center distance p of the plurality of recessed portions 112.

The nitride ceramic base material (base plate) can be used as an electronic component. For example, a semiconductor element may be mounted on the circuit layer 132 of the nitride ceramic base material (base plate) via solder.

### [Examples]

### (Example 1)

In Example 1, the nitride ceramic base material 100 was manufactured as follows.

The nitride ceramic base material 100 was a silicon nitride sintered body base material having a thickness of 0.32 mm.

The scribe line 110 (the plurality of recessed portions 112) was formed by a carbon dioxide laser. The depth d of the recessed portion 112 (for example, Fig. 2), the opening width w of the recessed portion 112 (for example, Fig. 2), the inter-center distance p of the plurality of recessed portions 112 (for example, Fig. 2), and the tip angle θ of the recessed portion 112 (for example, Fig. 3) were as shown in Table 1.

### (Examples 2 to 7 and Comparative Examples 1 to 5)

In each of Examples 2 to 7 and Comparative Examples 1 to 5, the depth d of the recessed portion 112 (for example, Fig. 2), the opening width w of the recessed portion 112 (for example, Fig. 2), the inter-center distance p of the plurality of recessed portions 112 (for example, Fig. 2), the tip angle θ of the recessed portion 112 (for example, Fig. 3), and the types of lasers used to form the scribe line 110 were as shown in Table 1. Examples 2 to 7 and Comparative Examples 1 to 5 were the same as those of Example 1 except for the points shown in Table 1.

### (Removal of Brazing Material from Nitride Ceramic Base Material)

As described with reference to Figs. 7 to 10, the brazing material 120 and the metal layer 130 were selectively etched using the resist 140 and the etching solution. Furthermore, the brazing material 120 remaining in the nitride ceramic base material 100 (for example, the brazing material 120 remaining in the scribe line 110 (recessed portions 112)) was removed by a solution.

A residue of the brazing material 120 in each of Examples 1 to 7 and Comparative Examples 1 to 4 is as shown in Table 1. In the column of "Removal of brazing material" in Table 1, "o" indicates that no residue of the brazing material 120 was confirmed in the scribe line 110 (recessed portions 112), and "x" indicates that a residue of the brazing material 120 was confirmed in the scribe line 110 (recessed portions 112)

### (Appearance of Scribe Line in SAT)

After the brazing material 120 was formed on the nitride ceramic base material 100, the nitride ceramic base material 100 and the metal layer 130 were bonded to each other by the brazing material 120. Thereafter, the bonding between the nitride ceramic base material 100 and the metal layer 130 was inspected by ultrasonic flaw detection inspection.

The appearance of the scribe line 110 in SAT in each of Examples 1 to 7 and Comparative Examples 1 to 4 was as shown in Table 1. In the column of "SAT" in Table 1, "O" indicates that no appearance of the scribe line 110 was confirmed in SAT of the ultrasonic flaw detection inspection, and "x" indicates that the appearance of the scribe line 110 was confirmed in SAT of the ultrasonic flaw detection inspection.

### (Breakage of Nitride Ceramic Base Material)

After the brazing material 120 remaining in the nitride ceramic base material 100 was removed, the nitride ceramic base material 100 was divided along the scribe line 110 by a four-point bending test.

The maximum bending stress when the nitride ceramic base material 100 in each of Examples 1 to 7 and Comparative Examples 1 to 4 was broken was as shown in Table 1.

A division failure rate of the nitride ceramic base material 100 in each of Examples 1 to 7 and Comparative Examples 1 to 4 was as shown in Table 1.

**[Table 1]**

| | Depth d (µm) | Opening width w (µm) | Inter-center distance p (µm) | Tip angle θ (°) | d/w | w/p | Laser | Removal of brazing material | SAT | Four-point bending test (MPa) | Division failure rate (%) |
|---|---|---|---|---|---|---|---|---|---|---|---|
| Example 1 | 60 | 80 | 80 | 55 | 0.75 | 1.00 | Carbon dioxide laser | O | O | 100 | 0.00 |
| Example 2 | 65 | 60 | 60 | 30 | 1.08 | 1.00 | Carbon dioxide laser | O | O | 120 | 0.00 |
| Example 3 | 65 | 60 | 60 | 30 | 1.08 | 1.00 | Fiber laser | O | O | 120 | 0.00 |
| Example 4 | 70 | 70 | 70 | 30 | 1.00 | 1.00 | Carbon dioxide laser | O | O | 110 | 0.00 |
| Example 5 | 80 | 80 | 80 | 40 | 1.00 | 1.00 | Carbon dioxide laser | O | O | 100 | 0.00 |
| Example 6 | 75 | 75 | 70 | 40 | 1.00 | 1.07 | Carbon dioxide laser | O | O | 95 | 0.00 |
| Example 7 | 70 | 80 | 77 | 35 | 0.88 | 1.04 | Fiber laser | O | O | 90 | 0.00 |
| Comparative Example 1 | 65 | 60 | 100 | 35 | 1.08 | 0.60 | Carbon dioxide laser | O | O | 150 | 1.00 |
| Comparative Example 2 | 40 | 89 | 85 | 70 | 0.45 | 1.05 | Carbon dioxide laser | O | O | 180 | 2.00 |
| Comparative Example 3 | 100 | 83 | 79 | 20 | 1.20 | 1.05 | Fiber laser | X | O | 90 | 0.00 |
| Comparative Example 4 | 50 | 110 | 95 | 75 | 0.45 | 1.16 | Fiber laser | O | X | 110 | 0.00 |

From Comparative Example 1, in a case where a ratio w/p is equal to or smaller than 0.60, favorable breakage of the nitride ceramic base material 100 would be difficult to be achieved.

From Comparative Example 2, in a case where a ratio d/w is equal to or smaller than 0.45, favorable breakage of the nitride ceramic base material 100 would be difficult to be achieved.

From Comparative Example 3, in a case where a ratio d/w is equal to or greater than 1.20, favorable removal of the brazing material 120 from the nitride ceramic base material 100 would be difficult to be achieved.

From Comparative Example 4, in a case where a ratio w/p is equal to or greater than 1.16, reduction of the appearance of the scribe line 110 in SAT would be difficult to be achieved.

From these examinations, the ratio d/w may be, for example, equal to or greater than 0.70 and equal to or smaller than 1.10, and preferably equal to or greater than 0.75 and equal to or smaller than 1.08, and the ratio w/p may be, for example, equal to or greater than 1.00 and equal to or smaller than 1.10, and preferably, equal to or greater than 1.00 and equal to or smaller than 1.07.

Although the embodiment of the present invention has been described with reference to the drawings, these are an example of the present invention, and various configurations other than the above can be adopted, as long as falling within the scope of the claims which define the present invention.

### REFERENCE SIGNS LIST

- 100:: nitride ceramic base material
- 102:: first surface
- 104:: second surface
- 110:: scribe line
- 110a:: first scribe line
- 110b:: second scribe line
- 112:: recessed portion
- 114:: ridge
- 120:: brazing material
- 130:: metal layer
- 132:: circuit layer
- 134:: heat dissipation layer
- 140:: resist

## Claims

1. A method of manufacturing a nitride ceramic substrate, the method comprising:
forming a scribe (110) line on a first surface (102) of a nitride ceramic base material (100) by a laser; and
dividing the nitride ceramic base material along the scribe line (110),
wherein the scribe line (110) comprises a plurality of recessed portions (112) formed in a row on the first surface (102) of the nitride ceramic base material (100), and
the opening width (w) of each of the plurality of recessed portions (112) is equal to or greater than 1.00 times and equal to or smaller than 1.10 times an inter-center distance (p) of the plurality of recessed portions (112),
**characterized in that**
a depth (d) of each of the plurality of recessed portions (112) is equal to or greater than 0.70 times and equal to or smaller than 1.10 times an opening width (w) of each of the plurality of recessed portions (112).

2. The method of manufacturing a nitride ceramic substrate according to claim 1,
wherein the forming the scribe line (110) forms a ridge (114) around each of the plurality of recessed portions (112).

3. The method of manufacturing a nitride ceramic substrate according to claim 2, further comprising
removing the ridge (114) around each of the plurality of recessed portions (112) after forming the scribe line (110).

4. The method of manufacturing a nitride ceramic substrate according to any one of claims 1 to 3,
wherein the depth (d) of each of the plurality of recessed portions (112) is equal to or greater than 9/64 times and equal to or smaller than 2/9 times a thickness (t) of the nitride ceramic base material (100).

5. The method of manufacturing a nitride ceramic substrate according to any one of claims 1 to 4,
wherein the depth (d) of each of the plurality of recessed portions (112) is equal to or greater than 45 um and equal to or smaller than 90 um.

6. The method of manufacturing a nitride ceramic substrate according to any one of claims 1 to 5,
wherein the scribe line (110) comprises a first scribe line (110a) comprising a first group of recessed portions (112) of the plurality of recessed portions (112) and extending in a first direction, and a second scribe line (110b) comprising a second group of recessed portions (112) of the plurality of recessed portions (112) and extending in a second direction intersecting the first direction, and
the recessed portion (112) located closest to the first scribe line (110a) among the second group of recessed portions (112) is not overlapped with any of the first group of recessed portions (112).

7. The method of manufacturing a nitride ceramic substrate according to claim 6,
wherein a center of the recessed portion (112) located closest to the first scribe line (110a) among the second group of recessed portions (112) is spaced apart from a center line of the first scribe line (110a) in the second direction by a distance (g2) equal to or smaller than 1.50 times an inter-center distance (p2) of the second group of recessed portions (112).

8. The method of manufacturing a nitride ceramic substrate according to any one of claims 1 to 5,
wherein the nitride ceramic base material (100) is a silicon nitride base material or an aluminum nitride base material.

9. The method of manufacturing a nitride ceramic substrate according to any one of claims 1 to 8,
wherein the nitride ceramic base material (100) is a silicon nitride sintered body base material.

10. A nitride ceramic base material (100) comprising
a first surface (102) on which a scribe line (110) is formed,
wherein the scribe line (110) comprises a plurality of recessed portions (112) formed in a row on the first surface (102), and
the opening width (w) of each of the plurality of recessed portions (112) is equal to or greater than 1.00 times and equal to or smaller than 1.10 times an inter-center distance (p) of the plurality of recessed portions (112)
**characterized in that**
a depth (d) of each of the plurality of recessed portions (112) is equal to or greater than 0.70 times and equal to or smaller than 1.10 times an opening width (w) of each of the plurality of recessed portions (112).

11. The nitride ceramic base material (100) according to claim 10,
wherein the nitride ceramic base material (100) is a silicon nitride sintered body base material.

## Patentansprüche

1. Verfahren zur Herstellung eines Nitridkeramiksubstrats, wobei das Verfahren umfasst:
Ausbilden einer Ritzlinie (110) auf einer ersten Oberfläche (102) eines Nitridkeramik-Grundmaterials (100) durch einen Laser; und
Teilen des Nitridkeramik-Grundmaterials entlang der Ritzlinie (110),
wobei die Ritzlinie (110) eine Vielzahl von vertieften Abschnitten (112) umfasst, die in einer Reihe auf der ersten Oberfläche (102) des Nitridkeramik-Grundmaterials (100) ausgebildet sind, und
wobei die Öffnungsbreite (w) jedes der Vielzahl von vertieften Abschnitten (112) gleich oder größer als das 1,00-fache und gleich oder kleiner als das 1, 10-fache eines Mittenabstands (p) der Vielzahl von vertieften Abschnitten (112) ist,
**dadurch gekennzeichnet, dass**
eine Tiefe (d) von jedem der Vielzahl von vertieften Abschnitten (112) gleich oder größer als das 0,70-fache und gleich oder kleiner als das 1,10-fache einer Öffnungsbreite (w) von jedem der Vielzahl von vertieften Abschnitten (112) ist.

2. Verfahren zur Herstellung eines Nitridkeramiksubstrats nach Anspruch 1,
wobei das Ausbilden der Ritzlinie (110) einen Steg (114) um jeden der Vielzahl von vertieften Abschnitten (112) bildet.

3. Verfahren zur Herstellung eines Nitrid-Keramiksubstrats nach Anspruch 2, das ferner Folgendes umfasst
Entfernen des Steges (114) um jeden der Vielzahl von vertieften Abschnitten (112) nach dem Ausbilden der Ritzlinie (110).

4. Verfahren zur Herstellung eines Nitridkeramiksubstrats nach einem der Ansprüche 1 bis 3,
wobei die Tiefe (d) jedes der Vielzahl von vertieften Abschnitten (112) gleich oder größer als das 9/64-fache und gleich oder kleiner als das 2/9-fache einer Dicke (t) des Nitridkeramik-Grundmaterials (100) ist.

5. Verfahren zur Herstellung eines Nitridkeramiksubstrats nach einem der Ansprüche 1 bis 4,
wobei die Tiefe (d) jedes der Vielzahl von vertieften Abschnitten (112) gleich oder größer als 45 um und gleich oder kleiner als 90 um ist.

6. Verfahren zur Herstellung eines Nitridkeramiksubstrats nach einem der Ansprüche 1 bis 5,
wobei die Ritzlinie (110) eine erste Ritzlinie (110a) umfasst, die eine erste Gruppe von vertieften Abschnitten (112) der Vielzahl von vertieften Abschnitten (112) umfasst und sich in einer ersten Richtung erstreckt, und eine zweite Ritzlinie (110b), die eine zweite Gruppe von vertieften Abschnitten (112) der Vielzahl von vertieften Abschnitten (112) umfasst und sich in einer zweiten Richtung erstreckt, die die erste Richtung schneidet, und
der vertiefte Abschnitt (112), der sich unter der zweiten Gruppe von vertieften Abschnitten (112) am nächsten an der ersten Ritzlinie (110a) befindet, nicht mit irgendeinem der ersten Gruppe von vertieften Abschnitten (112) überlappt ist.

7. Verfahren zur Herstellung eines Nitridkeramiksubstrats nach Anspruch 6,
wobei eine Mitte des vertieften Abschnitts (112), der am nächsten zu der ersten Ritzlinie (110a) unter der zweiten Gruppe von vertieften Abschnitten (112) angeordnet ist, von einer Mittellinie der ersten Ritzlinie (110a) in der zweiten Richtung um einen Abstand (g2) beabstandet ist, der gleich oder kleiner als das 1,50-fache eines Mittenabstands (p2) der zweiten Gruppe von vertieften Abschnitten (112) ist.

8. Verfahren zur Herstellung eines Nitridkeramiksubstrats nach einem der Ansprüche 1 bis 5,
wobei das Nitridkeramik-Grundmaterial (100) ein Siliziumnitrid-Grundmaterial oder ein Aluminiumnitrid-Grundmaterial ist.

9. Verfahren zur Herstellung eines Nitridkeramiksubstrats nach einem der Ansprüche 1 bis 8,
wobei das Nitridkeramik-Basismaterial (100) ein Siliziumnitrid-Sinterkörper-Basismaterial ist.

10. Nitridkeramik-Basismaterial (100), umfassend
eine erste Fläche (102), auf der eine Ritzlinie (110) ausgebildet ist,
wobei die Ritzlinie (110) eine Vielzahl von vertieften Abschnitten (112) umfasst, die in einer Reihe auf der ersten Oberfläche (102) ausgebildet sind, und
die Öffnungsbreite (w) jedes der Vielzahl von vertieften Abschnitten (112) gleich oder größer als das 1,00-fache und gleich oder kleiner als das 1, 10-fache eines Mittenabstands (p) der Vielzahl von vertieften Abschnitten (112) ist
**dadurch gekennzeichnet, dass**
eine Tiefe (d) von jedem der Vielzahl von vertieften Abschnitten (112) gleich oder größer als das 0,70-fache und gleich oder kleiner als das 1,10-fache einer Öffnungsbreite (w) von jedem der Vielzahl von vertieften Abschnitten (112) ist.

11. Nitridkeramisches Basismaterial (100) nach Anspruch 10,
wobei das Nitridkeramik-Basismaterial (100) ein Siliziumnitrid-Sinterkörper-Basismaterial ist.

## Revendications

1. Procédé de fabrication d'un substrat céramique à base de nitrure, comprenant :
former une ligne de traçage (110) sur une première surface (102) d'un matériau de base en céramique nitrure (100) au moyen d'un laser ; et
diviser le matériau de base en céramique nitrurée le long de la ligne de traçage (110),
dans lequel la ligne de traçage (110) comprend une pluralité de parties évidées (112) formées en rangée sur la première surface (102) du matériau de base en céramique nitrure (100), et
la largeur d'ouverture (w) de chacune de la pluralité de parties évidées (112) est égale ou supérieure à 1,00 fois et égale ou inférieure à 1,10 fois une distance inter-centres (p) de la pluralité de parties évidées (112),
**caractérisé par le fait que**
une profondeur (d) de chacune de la pluralité de parties évidées (112) est égale ou supérieure à 0,70 fois et égale ou inférieure à 1,10 fois une largeur d'ouverture (w) de chacune de la pluralité de parties évidées (112).

2. Procédé de fabrication d'un substrat céramique nitruré selon la revendication 1,
dans lequel la formation de la ligne de traçage (110) forme une arête (114) autour de chacune de la pluralité de parties évidées (112) .

3. Procédé de fabrication d'un substrat céramique nitruré selon la revendication 2, comprenant en outre
enlever l'arête (114) autour de chacune de la pluralité de parties évidées (112) après avoir formé la ligne de traçage (110).

4. Procédé de fabrication d'un substrat céramique nitruré selon l'une quelconque des revendications 1 à 3,
dans lequel la profondeur (d) de chacune de la pluralité de parties évidées (112) est égale ou supérieure à 9/64 fois et égale ou inférieure à 2/9 fois une épaisseur (t) du matériau de base en céramique nitrure (100).

5. Procédé de fabrication d'un substrat céramique nitruré selon l'une quelconque des revendications 1 à 4,
dans lequel la profondeur (d) de chacune de la pluralité de parties évidées (112) est égale ou supérieure à 45 um et égale ou inférieure à 90 µm.

6. Procédé de fabrication d'un substrat céramique nitruré selon l'une quelconque des revendications 1 à 5,
dans lequel la ligne de traçage (110) comprend une première ligne de traçage (110a) comprenant un premier groupe de parties évidées (112) de la pluralité de parties évidées (112) et s'étendant dans une première direction, et une deuxième ligne de traçage (110b) comprenant un deuxième groupe de parties évidées (112) de la pluralité de parties évidées (112) et s'étendant dans une deuxième direction croisant la première direction, et
la partie évidée (112) située le plus près de la première ligne de traçage (110a) parmi le deuxième groupe de parties évidées (112) n'est chevauchée par aucune des parties évidées du premier groupe de parties évidées (112).

7. Procédé de fabrication d'un substrat céramique nitruré selon la revendication 6,
dans lequel un centre de la partie évidée (112) située le plus près de la première ligne de traçage (110a) parmi le deuxième groupe de parties évidées (112) est espacé d'une ligne centrale de la première ligne de traçage (110a) dans la deuxième direction d'une distance (g2) égale ou inférieure à 1,50 fois une distance inter-centres (p2) du deuxième groupe de parties évidées (112).

8. Procédé de fabrication d'un substrat céramique nitruré selon l'une quelconque des revendications 1 à 5,
dans lequel le matériau de base en céramique nitrurée (100) est un matériau de base en nitrure de silicium ou un matériau de base en nitrure d'aluminium.

9. Procédé de fabrication d'un substrat céramique nitruré selon l'une quelconque des revendications 1 à 8,
dans lequel le matériau de base en céramique au nitrure (100) est un matériau de base fritté au nitrure de silicium.

10. Matériau de base en céramique de nitrure (100) comprenant
une première surface (102) sur laquelle est formée une ligne de traçage (110),
dans lequel la ligne de traçage (110) comprend une pluralité de parties évidées (112) formées en rangée sur la première surface (102), et
la largeur d'ouverture (w) de chacune de la pluralité de parties évidées (112) est égale ou supérieure à 1,00 fois et égale ou inférieure à 1, 10 fois une distance inter-centres (p) de la pluralité de parties évidées (112).
**caractérisé par le fait que**
une profondeur (d) de chacune de la pluralité de parties évidées (112) est égale ou supérieure à 0,70 fois et égale ou inférieure à 1,10 fois une largeur d'ouverture (w) de chacune de la pluralité de parties évidées (112).

11. Matériau de base en céramique nitrurée (100) selon la revendication 10,
dans lequel le matériau de base en céramique au nitrure (100) est un matériau de base fritté au nitrure de silicium.
